# EUROPÄISCHE PATENTSCHRIFT

(11) **EP 1 931 187 B1**
(45) Veröffentlichungstag und Bekanntmachung des Hinweises auf die Patenterteilung: **28.07.2010**
(21) Anmeldenummer: 06025153.5
(22) Anmeldetag: 05.12.2006
(51) Int. Cl.: H05K 5/02, H05K 7/14

(54) **Befestigungseinrichtung für elektronische Baugruppen sowie elektronisches Gerät mit einer derartigen Befestigungseinrichtung**
Fastening device for electronic components and electronic device with such a fastening device
Dispositif de fixation pour modules électroniques ainsi qu'un appareil électronique doté d'un tel dispositif de fixation

(43) Veröffentlichungstag der Anmeldung: 11.06.2008
(73) Patentinhaber: SIEMENS AKTIENGESELLSCHAFT, 80333 München (DE)
(72) Erfinder: Kreutzer, Rainer, 92637 Weiden (DE)

(56) Entgegenhaltungen:
- EP-A- 1 109 277
- EP-A1- 0 626 712
- DE-C1- 19 547 011
- FR-A1- 2 590 104

## Beschreibung

Die Erfindung betrifft eine Befestigungseinrichtung zur Befestigung und/oder elektrischen Kontaktierung einer ersten elektronischen Baugruppe an eine zweite elektronische Baugruppe. Die Baugruppen weisen jeweils einen Schaltungsträger für elektronische Bauteile auf. Es ist zumindest ein erstes Kontaktelement auf einer Kontaktierungsseite der ersten Baugruppe angeordnet, welches jeweils mit einem, auf einer Anschlussseite der zweiten Baugruppe angeordneten zweiten Kontaktelement korrespondiert.

Eine Befestigungseinrichtung mit den Merkmalen des Oberbegriffs des Anspruchs 1 ist aus der FR2590104 Schrift bekannt.

Die Erfindung betrifft weiter ein elektronisches Gerät, insbesondere ein Halbleiterleistungsmodul, mit einer ersten und zweiten elektronischen Baugruppe mit jeweils einem Schaltungsträger für elektronische Bauteile. Es ist zumindest ein erstes Kontaktelement auf einer Kontaktierungsseite der ersten Baugruppe angeordnet, welches jeweils mit einem, auf einer Anschlussseite der zweiten Baugruppe angeordneten zweiten Kontaktelement korrespondiert.

Derartige Befestigungseinrichtungen sind allgemein bekannt. Bekannt ist auch, dass eine Vielzahl von stift- oder buchsenförmigen Kontaktelementen in einer oder auch mehreren Reihen auf einer Kontaktierungsseite eines Schaltungsträgers einer elektronischen Baugruppe angeordnet sein kann. Der Schaltungsträger kann eine oder auch zwei Kontaktierungsseiten zur Befestigung und/oder Kontaktierung mit einer oder zwei weiteren Baugruppen aufweisen.

Die Kontaktelemente können in entsprechende Aussparungen, wie z.B. in Bohrungen, im Schaltungsträger eingesteckt und dann, wie z.B. mittels eines Schwall-Lötverfahrens, am Schaltungsträger kontaktiert werden. Alternativ können die Kontaktelemente auf dem Schaltungsträger aufgeklebt und dann verlötet werden oder in entsprechende Aussparungen im Schaltungsträger eingepresst werden.

Bei den Schaltungsträgern handelt es sich typischerweise um eine ein- oder zweiseitig kaschierte Leiterplatte. Eine solche Leiterplatte weist eine Isolationsschicht auf, die beidseitig mit einer Kupferschicht oder einer Kupferlage umgeben ist. Mittels eines Belichtungs- und Ätzungsprozesses bleiben von den Kupferschichten nur noch die Leiterbahnen, Kontaktflächen und dergleichen, das heißt die gedruckte Schaltung, übrig. Die Isolationsschicht kann z.B. aus Epoxydharz hergestellt sein. Sie kann, insbesondere eine Keramik sein, wenn auf der Leiterplatte elektronische Bauelemente, insbesondere Leistungshalbleiter, mit einer hohen Verlustleistung angeordnet sind. Eine solche Leiterplatte bzw. ein solcher Schaltungsträger wird auch als DCB (für direct copper bonding) bezeichnet.

Die stift- oder buchsenförmigen Kontaktelemente korrespondieren mit buchsen- oder stiftförmigen Kontaktelementen auf einer Anschlussseite einer weiteren elektronischen Baugruppe. Die weitere elektronische Baugruppe kann eine Anschlussseite oder auch zwei Anschlussseiten aufweisen. Zur Befestigung und/oder Kontaktierung werden die Kontaktelemente der einen Baugruppe mit den korrespondierenden Kontaktelementen der anderen Baugruppe verbunden. Die Verbindung ist vorzugsweise eine Steckverbindung und insbesondere eine lösbare Steckverbindung.

Aus dem Stand der Technik sind weiterhin elektronische Geräte bekannt, welche eine erste und zweite elektronische Baugruppe aufweisen. Ein derartiges Gerät ist z.B. ein Leistungshalbleitermodul. Es weist typischerweise ein Leistungsteil und ein Ansteuerteil auf, welche jeweils separate Baugruppen bilden. Das Leistungsteil weist üblicherweise Leistungshalbleiter, wie z.B. einen IGBT-Transistor, mit einer hohen Verlustleistung im zwei- oder dreistelligen Wattbereich auf. Die Leistungshalbleiter sind daher typischerweise aufgrund der hohen Temperaturentwicklung auf einem DCB angeordnet. Ein derartiges Leistungsteil kann zur Kühlung der Leistungshalbleiter einen oder mehrere Kühlkörper aufweisen. Oft ist das Leistungsteil in einem eigenem Gehäuse untergebracht.

Das Ansteuerteil ist aus thermischen Gründen vom Leistungsteil separiert, wobei das Ansteuerteil vorzugsweise am Gehäuse des Leistungsteils befestigt ist, wie z.B. festgeschraubt oder eingeklipst. Zur Ansteuerung der Leistungshalbleiter im Leistungsteil dienen vorzugsweise die eingangs beschriebenen Kontaktelemente.

Fertigungstoleranzen der einzelnen Baugruppen sowie des Gehäuses des Leistungsteils sowie Veränderungen in den Abmessungen aufgrund der großen Temperaturunterschiede zwischen dem Leistungsteil und dem Ansteuerteil können zu einem Versatz zwischen den korrespondierenden Kontaktelementen führen.

Dies führt nachteilig zu mechanischen Spannungen bei den Kontaktelementen. Ein Ausfall eines oder mehrerer Kontakte kann die Folge sein.

Ein weiterer Nachteil ist die erschwerte Montage der Baugruppen, wenn die Lage der Kontaktelemente der einen Baugruppe nicht genau mit der Lage der Kontaktelemente der anderen Baugruppe übereinstimmt.

Es ist eine Aufgabe der Erfindung, eine Befestigungseinrichtung anzugeben, welche die zuvor genannten Probleme behebt.

Es ist eine weitere Aufgabe der Erfindung, ein geeignetes elektronisches Gerät, insbesondere ein Halbleiterleistungsmodul, mit einer derartigen Befestigungseinrichtung anzugeben.

Die Aufgabe wird durch eine Befestigungseinrichtung mit den Merkmalen des Patentanspruchs 1 gelöst. Vorteilhafte Ausgestaltungen sind in den abhängigen Ansprüchen 2 bis 23 angegeben. Im Anspruch 23 ist ein elektronisches Gerät mit einer erfindungsgemäßen Befestigungseinrichtung genannt. In den Ansprüchen 24 und 25 sind vorteilhafte Ausgestaltungen des elektronischen Gerätes angegeben.

Wesentliches Merkmal der Erfindung ist eine zweigelenkige Verbindung zwischen den zwei miteinander zu kontaktierenden Schaltungsträgern.

Erfindungsgemäß weist die Befestigungseinrichtung ein Verbindungselement mit zwei sich gegenüberliegenden Endstücken auf. Das erste Endstück ist mit dem ersten Kontaktelement und das zweite Endstück mit dem zweiten Kontaktelement kontaktierbar. Die jeweiligen Endstücke sind mit dem jeweiligen Kontaktelement gelenkig verbunden.

Dadurch ist vorteilhaft eine anpassbare und zugleich biegespannungsfreie Verbindung zwischen den zugehörigen Kontaktelementen möglich. Die gelenkige Ausführung ermöglicht somit einen Toleranzausgleich zwischen den korrespondierenden Kontaktelementen.

Im Idealfall, das heißt für den Fall, dass kein Versatz zwischen der ersten und zweiten elektronischen Baugruppe vorliegt, liegen die Längsachsen der Kontaktelemente und die Längsachse des Verbindungselementes in einer Flucht. Typischerweise verläuft die Längsachse der Kontaktelemente parallel zur Normalen der Kontaktierungs- bzw. Anschlussseite der ersten bzw. zweiten elektronischen Baugruppe.

Die jeweiligen Endstücke des Verbindungselementes im ersten und/oder zweiten Kontaktelement sind unter Kraftaufwendung axial verschiebbar. Mit "axial" ist eine Richtung parallel zur Längsachse des Verbindungselementes bezeichnet. Dadurch ist neben der ausgleichenden Schwenkbewegung zusätzlich eine translatorische Ausgleichsbewegung möglich. Es ist folglich ein noch größerer Toleranzausgleich möglich.

Im Besonderen weist das Verbindungselement eine Längsachse auf. Zudem ist das Verbindungselement im Wesentlichen rotationssymmetrisch ausgebildet. Dadurch vereinfacht sich der mechanische Aufbau eines derartigen Verbindungselementes.

Nach einer Ausführungsform sind die beiden Endstücke des Verbindungselementes buchsenförmig und die beiden Kontaktelemente stiftförmig ausgebildet. Eine solche Kontaktierungstechnik ist seit langem bewährt.

Einer besonderen Ausführungsform zufolge bilden die buchsenförmigen ausgebildeten Endstücke einen Klemmring aus. Der Klemmdurchmesser ist geringfügig kleiner als der Außendurchmesser des zugehörigen stiftförmigen Kontaktelementes. Das Verbindungselement weist zumindest einen zur axialen Mitte des Verbindungselementes hin anschließenden Hohlraum auf. Der Innendurchmesser des Hohlraums ist geringfügig größer als der Außendurchmesser des stiftförmigen Kontaktelementes.

Dadurch ist ein erheblich größerer Schwenkbereich der beiden gelenkig mit dem Verbindungselement verbundenen Kontaktelemente möglich. Die Schwenkung der stiftförmigen Kontaktelemente erfolgt im Wesentlichen um den jeweiligen Klemmbereich als Schwenkpunkt. Durch den im Vergleich zu den radialen Abmessungen des in das Verbindungselement hineinragenden stiftförmigen Endes größeren Hohlraum ist eine schwenkende Ausgleichsbewegung im Hohlraum des Verbindungselementes möglich.

In einer bevorzugten Ausführungsform weisen die Endstücke des Verbindungselementes axial verlaufende Schlitze zum jeweiligen axialen Ende hin auf. Zwischen den Schlitzen sind Kontaktfinger ausgebildet.

Durch die Schlitzung der beiden Endstücke des Verbindungselementes entstehen federnde Kontaktfinger. Die axialen Enden der Kontaktfinger bilden dabei den Klemmring, dessen Durchmesser sich durch die Federung der Kontaktfinger geringfügig vergrößern kann. Dadurch ist eine noch größere Schwenkung möglich. Zugleich sorgt die Federung der Kontaktfeder dafür, dass die Kontaktfedern nicht abheben und immer Kontakt zum kontaktierten Kontaktelement haben. Vorzugsweise sind die Spitzen der Kontaktfinger angefast, so dass diese möglichst plan an der radialen Außenfläche des stiftförmigen Kontaktelementes anliegen.

Nach einer weiteren besonderen Ausführungsform sind die Kontaktfinger in Richtung zum jeweiligen axialen Ende und zur Längsachse des Verbindungselementes hin gebogen, insbesondere gecrimpt. Dies kann z.B. mittels eines Biegeverfahrens bewerkstelligt werden.

Ein derartiges erfindungsgemäßes Verbindungselement kann in vorteilhafter Weise aus einem hohlzylindrischen Grundkörper, wie z.B. einer Hülse, hergestellt werden, bei dem zuerst die axialen Schlitze in die Endstücke des Verbindungselementes eingebracht werden und bei dem dann die Kontaktfinger entlang einer Biegekante zur Längsachse hin gebogen werden. Durch den Biegevorgang werden der Klemmring und zugleich der Hohlraum im Verbindungselement mit dem im Vergleich zum Durchmesser des Klemmrings größeren Innendurchmesser gebildet.

Alternativ oder zusätzlich weisen die buchsenförmig ausgebildeten Endstücke eine trichterförmige, den Klemmring ausbildende Einschnürung auf. Die trichterförmige Einschnürung bildet vorteilhaft eine zentrierende Aufnahme für die jeweils zu kontaktierenden stiftförmigen Kontaktelemente aus.

Vorzugsweise sind die stiftförmigen Kontaktelemente Drahtstifte. Diese sind in hohen Stückzahlen kostengünstig herstellbar.

Alternativ zu den zuvor beschriebenen Ausführungsformen kann das Verbindungselement stiftförmig und die beiden Kontaktelemente buchsenförmig ausgebildet sein. Insbesondere ist dann das Verbindungselement ein Drahtstift.

In diesem Fall bilden die buchsenförmigen Kontaktelemente einen Klemmring aus, dessen Klemmdurchmesser geringfügig kleiner ist als der Außendurchmesser des stiftförmigen Verbindungselementes. Die Kontaktelemente weisen in axialer Richtung zur Anschluss- bzw. zur Kontaktierungsseite hin jeweils einen an den Klemmring anschließenden Hohlraum auf. Mit "axial" ist eine Richtung parallel zur Längsachse des Kontaktelementes bezeichnet. Der Innendurchmesser des Klemmringes ist geringfügig größer als der Außendurchmesser des stiftförmigen Verbindungselementes.

Dadurch ist in analoger Weise wiederum ein erheblich größerer Schwenkbereich der beiden gelenkig mit dem Verbindungselement verbundenen Kontaktelemente möglich.

Gemäß einer Ausführungsform weist das Kontaktelement axial verlaufende Schlitze zum jeweiligen, der Anschluss- bzw. der Kontaktierungsseite gegenüberliegenden axialen Ende hin auf. Es sind Kontaktfinger zwischen den Schlitzen ausgebildet.

Dadurch entstehen wiederum federnde Kontaktfinger, die eine noch größere Schwenkung ermöglichen.

In entsprechender Weise können die Kontaktfinger zum jeweiligen, der Anschluss- bzw. der Kontaktierungsseite gegenüberliegenden axialen Ende und zu einer Längsachse des Kontaktelementes hin gebogen sein.

Zur zentrierenden Aufnahme kann das buchsenförmig ausgebildete Kontaktelement eine trichterförmige, den Klemmring ausbildende Einschnürung aufweisen.

Nach einer weiteren alternativen Ausführungsform ist das erste Endstück des Verbindungselementes buchsenförmig ausgebildet. Das zweite Endstück ist stiftförmig ausgebildet. Es ist das erste oder zweite Kontaktelement stiftförmig ausgebildet. Das zweite oder erste Kontaktelement ist buchsenförmig ausgebildet.

Diese Ausführungsform entspricht einer Kombination der beiden zuvor beschriebenen Grundformen des Verbindungselementes, das heißt mit ausschließlichen stiftförmigen oder buchsenförmigen Endstücken.

In analoger Weise kann das erste oder zweite stiftförmige Kontaktelement wiederum ein Drahtstift sein.

Weiterhin bildet in entsprechender Weise das buchsenförmige erste Endstück des Verbindungselementes einen Klemmring aus, dessen Klemmdurchmesser geringfügig kleiner ist als der Außendurchmesser des zugehörigen ersten oder zweiten Kontaktelementes. Das erste Endstück weist einen zur axialen Mitte hin anschließenden Hohlraum auf, dessen Innendurchmesser geringfügig größer ist als der Außendurchmesser des ersten oder zweiten Kontaktelementes.

Analog dazu kann das buchsenförmig ausgebildete erste Endstück axial verlaufende Schlitze zum axialen Ende hin aufweisen. Zwischen den Schlitzen sind wiederum die Kontaktfinger ausgebildet. Insbesondere sind die Kontaktfinger in Richtung zum axialen Ende und zur Längsachse des Verbindungselementes hin gebogen. Alternativ oder zusätzlich zur vorherigen Ausführungsform kann das buchsenförmig ausgebildete erste Endstück eine trichterförmige, den Klemmring ausbildende Einschnürung aufweisen. Das stiftförmige zweite Endstück des Verbindungselementes ist insbesondere ein Drahtstift.

Nach einer bevorzugten Ausführungsform bestehen die Kontaktelemente und das Verbindungselement aus verzinntem Kupfer oder aus Kupferlegierungen. Ein derartiger Werkstoff weist einen geringen ohmschen Widerstand, ein sehr gutes Kontaktverhalten sowie ein sehr gutes Lötverhalten auf.

Die Aufgabe der Erfindung wird weiterhin durch ein elektronisches Gerät mit einer erfindungsgemäßen Befestigungseinrichtung zur Befestigung und/oder Kontaktierung der ersten elektronischen Baugruppe an die zweite elektronische Baugruppe gelöst.

Nach einer bevorzugten Ausführungsform ist die zweite elektronische Baugruppe in einem Gehäuse untergebracht. Das Gehäuse weist zumindest eine Öffnung auf. Im Bereich der jeweiligen Öffnung ist ein erstes Endstück des Verbindungselementes der Befestigungseinrichtung angeordnet.

Insbesondere weist das Gehäuse eine Vielzahl von Öffnungen auf, die gleichfalls mit einer Vielzahl von Verbindungselementen korrespondiert. Die Öffnungen sind insbesondere Bohrungen oder Aussparungen mit einem kreisförmigen Querschnitt. Vorzugsweise ist der Durchmesser einer Öffnung etwas größer, so dass ein im Bereich der Öffnung befindliches Endstück genügend Spiel zum Innenrand der jeweiligen Öffnung hat.

Zur möglichen Kontaktierung sind vorzugsweise alle zweiten Endstücke der Verbindungselemente bereits mit den zweiten Kontaktelementen auf der zweiten Baugruppe verbunden. Die Abmessungen des jeweiligen Verbindungselementes sind derart auf die Abmessungen des zweiten Kontaktelementes abgestimmt, dass die mit den zweiten Kontaktelementen gelenkig verbundenen Verbindungselemente im Wesentlichen in Normalenrichtung zur Anschlussseite der zweiten Baugruppe ausgerichtet werden können. Im Anschluss kann das Gehäuse der zweiten Baugruppe mit den Öffnungen über die freistehenden Endstücke der Verbindungselemente gestülpt und fixiert werden. Durch das seitliche Spiel der Endstücke in den Öffnungen können Versätze zu den ersten Kontaktelementen der elektrisch zu kontaktierenden bzw. zu befestigenden ersten Baugruppe innerhalb des Spielbereichs ausgeglichen werden.

Im Besonderen ist das elektronische Gerät ein Leistungshalbleitermodul mit einem Ansteuerteil als erste elektronische Baugruppe und mit einem Halbleiter-Leistungsteil als zweite elektronische Baugruppe.

Die Erfindung sowie vorteilhafte Ausführungen der Erfindung werden im Weiteren anhand der nachfolgenden Figuren näher beschrieben. Es zeigen
- FIG 1: beispielhaft ein elektronisches Gerät mit zwei elektronischen Baugruppen und einer erfindungsgemäßen Befestigungseinrichtung in einer perspektivischen Darstellung,
- FIG 2: das elektronische Gerät gemäß FIG 1 mit zueinander leicht versetzt angeordneten Baugruppen in einer Schnittdarstellung,
- FIG 3: eine vergrößerte Darstellung eines mit einem Verbindungselement gelenkig verbundenen ersten Kontaktelementes gemäß der Erfindung,
- FIG 4: eine Außenansicht des in FIG 1 bis FIG 3 im Schnitt dargestellten Verbindungselementes,
- FIG 5: eine erste Ausführungsform der erfindungsgemäßen Befestigungseinrichtung,
- FIG 6: eine zweite Ausführungsform der erfindungsgemäßen Befestigungseinrichtung,
- FIG 7: eine dritte Ausführungsform der erfindungsgemäßen Befestigungseinrichtung,
- FIG 8: eine vierte Ausführungsform der erfindungsgemäßen Befestigungseinrichtung und
- FIG 9: eine fünfte Ausführungsform der erfindungsgemäßen Befestigungseinrichtung.

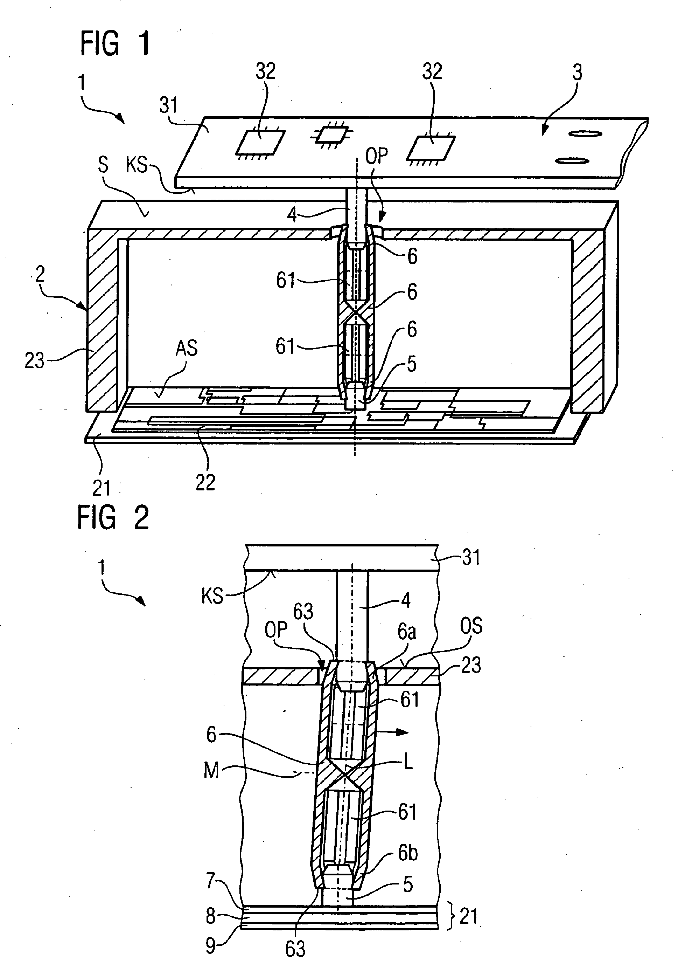

FIG 1 zeigt beispielhaft ein elektronisches Gerät 1 mit zwei elektronischen Baugruppen 2, 3 und einer erfindungsgemäßen Befestigungseinrichtung in einer perspektivischen Darstellung.

Bei dem elektronischen Gerät 1 handelt es sich beispielhaft um ein Halbleiter-Leistungsmodul mit einem Ansteuerteil als erste elektronische Baugruppe 3 und einem Leistungsteil 2 als zweite elektronische Baugruppe 2. Mit dem Bezugszeichen 21, 31 sind Schaltungsträger für die darauf angebrachten elektronischen Bauteile 22, 32 bezeichnet.

Das Leistungsteil 2 ist in einem Gehäuse 23, vorzugsweise aus einem wärmebeständigen Kunststoff oder aus einer Keramik, untergebracht. Das gezeigte Gehäuse 23 weist aus Gründen der Übersichtlichkeit beispielhaft nur eine Öffnung OP auf einer mit dem Bezugszeichen S bezeichneten Gehäuseaußenseite auf. Typischerweise weist das Gehäuse eine Vielzahl von Öffnungen OP, wie z.B. 16, auf. Die Öffnungen OP können z.B. rasterförmig angeordnet sein. Sie können in einer, zwei oder mehr Reihen angeordnet sein.

Es ist ein erstes Kontaktelement 4 auf einer Kontaktierungsseite KS der Ansteuereinheit 3 angeordnet, welches mit einem, auf einer Anschlussseite AS des Leistungsteils 2 angeordneten zweiten Kontaktelement 5 korrespondiert.

Erfindungsgemäß weist die Befestigungseinrichtung ein Verbindungselement 6 mit zwei sich gegenüberliegenden Endstücken 6a, 6b auf. Das das erste Endstück 6a ist mit dem ersten Kontaktelement 4 und das zweite Endstück 6b mit dem zweiten Kontaktelement 5 kontaktierbar. Die jeweiligen Endstücke 6a, 6b sind mit dem jeweiligen Kontaktelement 4, 5 gelenkig verbunden. Die Kontaktelemente 4, 5 und das Verbindungselement 6 bestehen vorzugsweise aus verzinntem Kupfer oder Kupferlegierungen.

Wie die FIG 1 weiterhin zeigt, ist im Bereich der dargestellten Öffnung OP das erste Endstück 6a des Verbindungselementes 6 angeordnet. Der Durchmesser der Öffnung OP ist etwas größer als der maximale Durchmesser des Endstücks 6a in diesem Bereich, wie z.B. in einem Bereich von 10% bis 25%.

FIG 2 zeigt das elektronische Gerät 1 gemäß FIG 1 mit zueinander leicht versetzt angeordneten Baugruppen 2, 3 in einer Schnittdarstellung.

Erfindungsgemäß wird der Versatz durch die zweigelenkige Ausführung der Befestigungseinrichtung ausgeglichen. Dies ist durch den in der FIG 2 eingezeichneten Pfeil symbolisiert. Wie FIG 2 weiter zeigt, erfahren dabei weder das erste noch das zweite Kontaktelement 4, 5 eine besonders hohe Biegebeanspruchung, wie die z.B. bei Befestigungseinrichtungen nach dem Stand der Technik der Fall ist. Unterstützt wird dies auch durch die mögliche axiale Verschiebbarkeit der Endstücke 6a, 6b des Verbindungselementes 6 im ersten und/oder zweiten Kontaktelement 4, 5, insbesondere bei einer größeren Schwenkbewegung.

Wie die FIG 2 weiterhin zeigt, weist das Verbindungselement 6 eine Längsachse L auf. Es ist zudem rotationssymmetrisch ausgebildet. Die beiden Endstücke 6a, 6b sind entsprechend der vorliegenden FIG 2 buchsenförmig und die beiden Kontaktelemente 4, 5 stiftförmig ausgebildet. Die stiftförmigen Kontaktelemente 4, 5 weisen eine zylindrische Form auf.

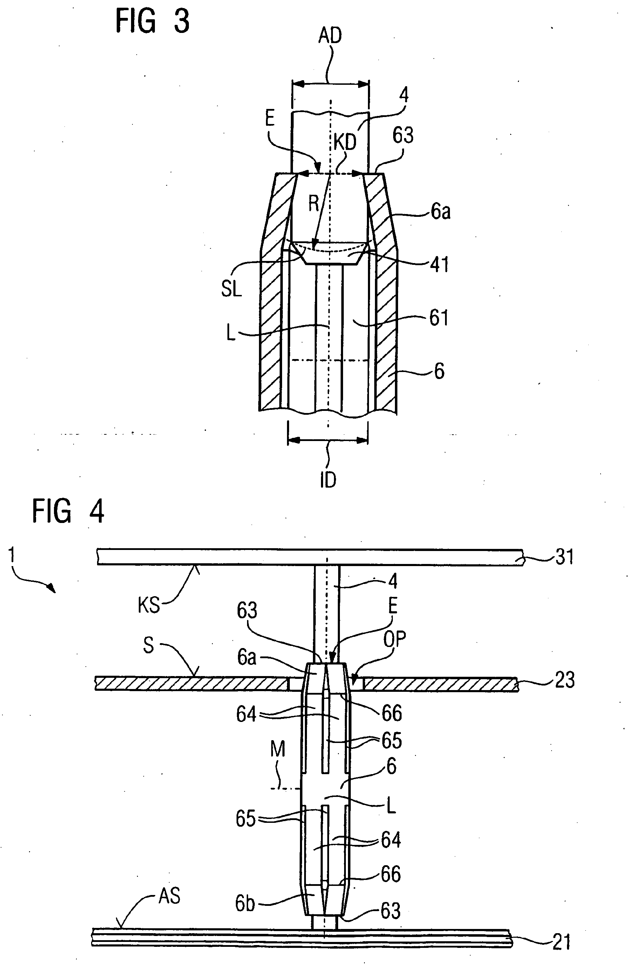

FIG 3 zeigt eine vergrößerte Darstellung eines mit einem Verbindungselement 6 gelenkig verbundenen ersten Kontaktelementes 4 gemäß der Erfindung.

Die buchsenförmigen Endstücke 6a, 6b, von denen für die detaillierten Darstellung nur das erste Endstück 6a dargestellt ist, bilden einen gestrichelt eingezeichneten Klemmring 63 aus. Dessen Klemmdurchmesser KD ist geringfügig kleiner als der mit AD bezeichnete (maximale) Außendurchmesser des zugehörigen Kontaktelementes 4. Das Verbindungselement 6 weist weiterhin zumindest einen zur axialen Mitte M des Verbindungselementes 6 hin anschließenden Hohlraum 61 auf (siehe auch FIG 2). Der (minimale) Innendurchmesser ID ist geringfügig größer als der Außendurchmesser AD des zugehörigen Kontaktelementes 4. Die Unterschiede der Durchmesser KD, AD, ID zueinander liegen typischerweise im Zehntelmillimeterbereich.

Im Beispiel der vorherigen FIG 2 weist das Verbindungselement 6 zwei Hohlräume 61 auf, die im mittleren axialen Bereich M durch ein massiv ausgeführtes Stück getrennt sind. Die beiden Hohlräume 61 sind beispielhaft in einem Vollzylinder eingebrachte Bohrungen. Durch das massive Mittenstück wird die Biegesteifigkeit des Verbindungselementes 6 erhöht. Alternativ kann der Hohlraum 61 sich über die gesamte axiale Länge des Verbindungselementes 6 erstrecken.

Mit dem Bezugszeichen R ist ein Schwenkradius bezeichnet, um den in etwa das in den Hohlraum 61 hineinragende stiftförmige Ende des ersten Kontaktelementes 4 schwenken kann. Mit SL ist die zugehörige Schwenklinie bezeichnet. Mit dem Bezugszeichen 41 ist ein beispielhaft angefastes Ende des Kontaktelementes 4 bezeichnet.

FIG 4 zeigt eine Außenansicht des in FIG 1 bis FIG 3 im Schnitt dargestellten Verbindungselementes 6.

Die Endstücke 6a, 6b weisen axial verlaufende Schlitze 65 zum jeweiligen axialen Ende E hin auf. Zwischen den Schlitzen 65 sind Kontaktfinger 64 ausgebildet. Weiterhin sind die Kontaktfinger 64 in Richtung zum jeweiligen axialen Ende E und zur Längsachse L des Verbindungselementes 6 hin gebogen. Im Beispiel der FIG 4 sind die Kontaktfinger 64 tangential entlang einer auf der zylindrischen Mantelfläche des Verbindungselementes 6 verlaufende Biegelinie bzw. Biegekante 66 gebogen. Mit "tangential" ist eine Richtung um die Längsachse L des Verbindungselementes 6 bezeichnet. Die Projektion der Biegekante 66 auf die Längsachse L liegt in axialer Richtung etwa im Bereich des äußeren Drittels bis zum äußeren Fünftel, gemessen ab der axialen Mitte M des Verbindungselementes 6. Die Schlitze 65 können, wie im Beispiel der FIG 4 gezeigt, in etwa ab der axialen Mitte M zum jeweiligen axialen Ende verlaufen, wobei vorzugsweise ein Mittenteil verbleibt, welches eine axiale Erstreckung in einem Bereich von 10 bis 25 % in Bezug auf die gesamte axiale Länge des Verbindungselementes 6 aufweist.

Weiterhin ist die Schlitzbreite so gewählt, dass die Spitzen der Kontaktfinger 64 nach dem Biegen zur Längsachse L hin einen geschlossenen Klemmring 63 bilden.

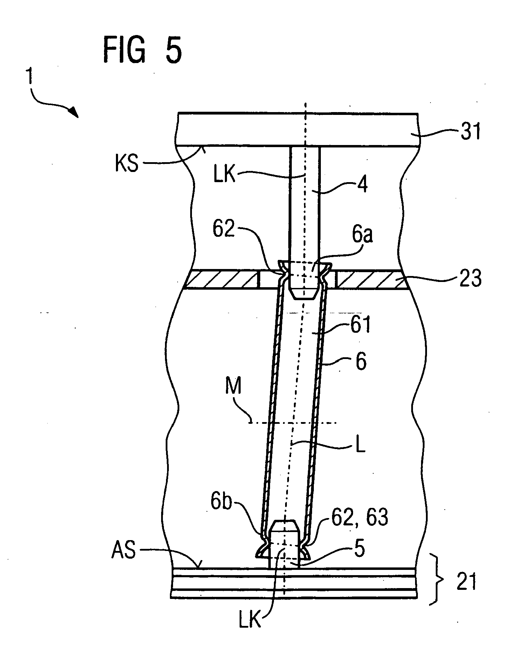

FIG 5 zeigt eine erste Ausführungsform der erfindungsgemäßen Befestigungseinrichtung.

In diesem Fall weisen die buchsenförmig ausgebildeten Endstücke 6a, 6b des Verbindungselementes 6 eine trichterförmige, den Klemmring 63 ausbildende Einschnürung 62 auf. Der Vorteil dieser Ausführungsform ist die denkbar einfache Herstellung des Verbindungselementes 6. Hierzu wird an den beiden Endbereichen einer hohlzylindrischen Hülse jeweils eine Einschnürung mittels eines Quetschvorganges eingebracht.

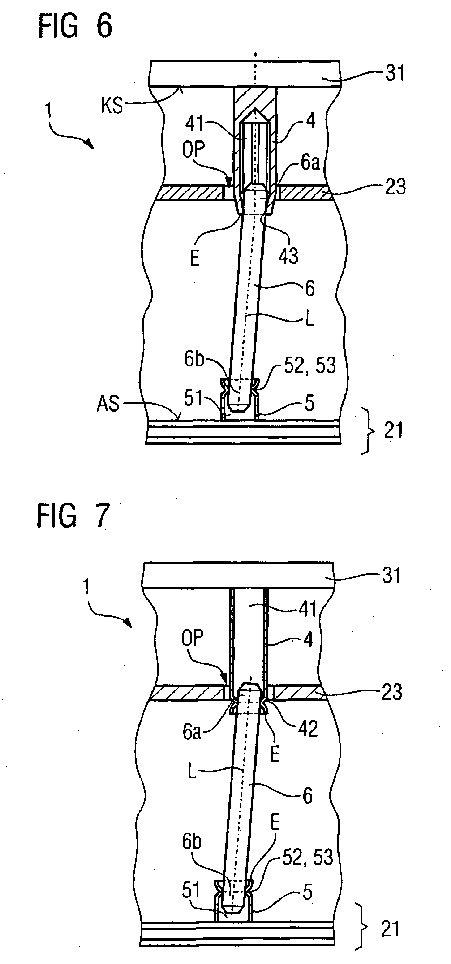

FIG 6 zeigt eine zweite Ausführungsform der erfindungsgemäßen Befestigungseinrichtung.

Bei dieser Ausführungsform sind das Verbindungselement 6 stiftförmig und die beiden Kontaktelemente 4, 5 buchsenförmig ausgebildet. Insbesondere ist das gezeigte Verbindungselement 6 ein Drahtstift mit einem im Wesentlichen konstanten Außendurchmesser.

Das im oberen Teil der FIG 6 dargestellte erste Kontaktelement 4 entspricht in Hinblick auf die Funktion und Ausgestaltung im Wesentlichen einem in FIG 1 bis FIG 4 gezeigten Verbindungselement 6, welches in der axialen Mitte M geteilt ist. Das im unteren Teil der FIG 6 dargestellte zweite Kontaktelement 4 entspricht in Hinblick auf die Funktion und Ausgestaltung im Wesentlichen einem in FIG 5 dargestellten Verbindungselement 6, welches in der axialen Mitte M geteilt ist. Zur Kontaktierung dieser beiden Kontaktelemente 4, 5 mit der Kontaktierungs- bzw. Anschlussseite AS können diese, in der FIG 6 nicht weiter dargestellte, Kontaktierungsflächen, Kontaktierungsbolzen oder dergleichen aufweisen.

FIG 7 zeigt eine dritte Ausführungsform der erfindungsgemäßen Befestigungseinrichtung.

Die dort gezeigte Ausführungsform unterscheidet sich von der in FIG 6 dadurch, dass beispielhaft zwei buchsenförmig ausgebildete Kontaktelemente 4, 5 mit jeweils einer trichterförmigen Einschnürung zur gelenkigen Verbindung mit dem stiftförmigen Verbindungselement 6 verwendet werden.

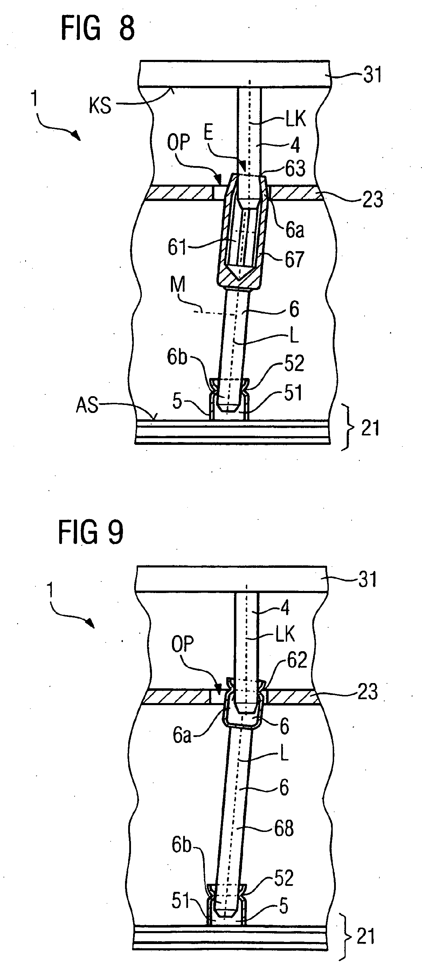

FIG 8 zeigt eine vierte Ausführungsform der erfindungsgemäßen Befestigungseinrichtung.

In diesem Fall ist das Verbindungselement 6 eine Kombination aus dem Verbindungselement 6 gemäß FIG 1 bis FIG4 und FIG 6. Dabei ist das erste Endstück 6a des Verbindungselementes 6 buchsenförmig und das zweite Endstück 6b stiftförmig ausgebildet. Zudem ist das erste oder zweite Kontaktelement 4, 5 stiftförmig und das zweite oder das erste Kontaktelement 5, 4 buchsenförmig ausgebildet. In Hinblick auf die Funktion und Ausgestaltung entspricht das kombinierte Verbindungselement 6 im Wesentlichen der in den vorherigen Figuren beschriebenen.

FIG 9 zeigt eine fünfte Ausführungsform der erfindungsgemäßen Befestigungseinrichtung.

Die dort dargestellte Ausführungsform unterscheidet sich von der gemäß FIG 8 dadurch, dass das erste Endstück 6b eine trichterförmige Einschnürung 62 aufweist. In Hinblick auf die Funktion und Ausgestaltung entspricht dieses kombinierte Verbindungselement 6 im Wesentlichen der in der FIG 8 beschriebenen.

## Patentansprüche

1. Befestigungseinrichtung zur Befestigung und/oder elektrischen Kontaktierung einer ersten elektronischen Baugruppe (3) an eine zweite elektronische Baugruppe (2), wobei die Baugruppen (2, 3) jeweils einen Schaltungsträger (21, 31) für elektronische Bauteile (22, 32) aufweisen und wobei zumindest ein erstes Kontaktelement (4) auf einer Kontaktierungsseite (KS) der ersten Baugruppe (3) angeordnet ist, welches jeweils mit einem, auf einer Anschlussseite (AS) der zweiten Baugruppe (2) angeordneten zweiten Kontaktelement (5) korrespondiert, wobei die Befestigungseinrichtung ein Verbindungselement (6) mit zwei sich gegenüberliegenden Endstücken (6a, 6b) aufweist, wobei das erste Endstück (6a) mit dem ersten Kontaktelement (4) und das zweite Endstück (6b) mit dem zweiten Kontaktelement (5) kontaktierbar ist und
wobei die jeweiligen Endstücke (6a, 6b) mit dem jeweiligen Kontaktelement (4, 5) gelenkig verbunden sind,
**dadurch gekennzeichnet, dass**
die jeweiligen Endstücke (6a, 6b) des Verbindungselementes (6) im ersten und/oder zweiten Kontaktelement (4, 5) unter Kraftaufwendung axial verschiebbar sind.

2. Befestigungseinrichtung nach Anspruch 1, **dadurch gekennzeichnet, dass** das Verbindungselement (6) eine Längsachse (L) aufweist und im Wesentlichen rotationssymmetrisch ausgebildet ist.

3. Befestigungseinrichtung nach einem der vorangegangenen Ansprüche, **dadurch gekennzeichnet, dass** die beiden Endstücke (6a, 6b) des Verbindungselementes (6) buchsenförmig und die beiden Kontaktelemente (4, 5) stiftförmig ausgebildet sind.

4. Befestigungseinrichtung nach Anspruch 3, **dadurch gekennzeichnet, dass** die buchsenförmigen Endstücke (6a, 6b) einen Klemmring (63) ausbilden, dessen Klemmdurchmesser (KD) geringfügig kleiner ist als der Außendurchmesser (AD) des zugehörigen stiftförmigen Kontaktelementes (4, 5), und dass das Verbindungselement (6) zumindest einen zur axialen Mitte (M) des Verbindungselementes (6) hin anschließenden Hohlraum (61) aufweist, dessen Innendurchmesser (ID) geringfügig größer ist als der Außendurchmesser (AD) des zugehörigen Kontaktelementes (4, 5)

5. Befestigungseinrichtung nach Anspruch 4, **dadurch gekennzeichnet, dass** die Endstücke (6a, 6b) axial verlaufende Schlitze (65) zum jeweiligen axialen Ende (E) hin aufweisen und dass Kontaktfinger (64) zwischen den Schlitzen (65) ausgebildet sind.

6. Befestigungseinrichtung nach Anspruch 5, **dadurch gekennzeichnet, dass** die Kontaktfinger (64) in Richtung zum jeweiligen axialen Ende (E) und zur Längsachse (L) des Verbindungselementes (6) hin gebogen sind.

7. Befestigungseinrichtung nach einem der Ansprüche 4 bis 6, **dadurch gekennzeichnet, dass** die buchsenförmig ausgebildeten Endstücke (6a, 6b) eine trichterförmige, den Klemmring (63) ausbildende Einschnürung (62) aufweisen.

8. Befestigungseinrichtung nach einem der Ansprüche 3 bis 7, **dadurch gekennzeichnet, dass** die stiftförmigen Kontaktelemente (4, 5) Drahtstifte sind.

9. Befestigungseinrichtung nach einem der Ansprüche 1 bis 2, **dadurch gekennzeichnet, dass** das Verbindungselement (6) stiftförmig und die beiden Kontaktelemente (4, 5) buchsenförmig ausgebildet sind.

10. Befestigungseinrichtung nach Anspruch 9, **dadurch gekennzeichnet, dass** das Verbindungselement (6) ein Drahtstift ist.

11. Befestigungseinrichtung nach Anspruch 9 oder 10, **dadurch gekennzeichnet, dass** die buchsenförmigen Kontaktelemente (4, 5) einen Klemmring (43, 53) ausbilden, dessen Klemmdurchmesser (KD) geringfügig kleiner ist als der Außendurchmesser (AD) des Verbindungselementes (6), und dass die Kontaktelemente (4, 5) in axialer Richtung zur Kontaktierungs- oder Anschlussseite (AS, KS) hin jeweils einen an den Klemmring (43, 53) anschließenden Hohlraum (41, 51) aufweisen, dessen Innendurchmesser (ID) geringfügig größer ist als der Außendurchmesser (AD) des Verbindungselementes (4, 5).

12. Befestigungseinrichtung nach Anspruch 11, **dadurch gekennzeichnet, dass** das Kontaktelement (4, 5) axial verlaufende Schlitze (65) zum jeweiligen, der Anschluss- bzw. der Kontaktierungsseite (AS, KS) gegenüberliegenden axialen Ende (E) hin aufweist und dass Kontaktfinger (64) zwischen den Schlitzen (65) ausgebildet sind.

13. Befestigungseinrichtung nach Anspruch 12, **dadurch gekennzeichnet, dass** die Kontaktfinger (64) zum jeweiligen, der Anschluss- bzw. der Kontaktierungsseite (AS, KS) gegenüberliegenden axialen Ende (E) und zu einer Längsachse (LK) des Kontaktelementes (4, 5) hin gebogen sind.

14. Befestigungseinrichtung nach einem der Ansprüche 11 bis 13, **dadurch gekennzeichnet, dass** das buchsenförmig ausgebildete Kontaktelement (4, 5) eine trichterförmige, den Klemmring (43, 53) ausbildende Einschnürung (42, 62) aufweist.

15. Befestigungseinrichtung nach einem der Ansprüche 1 bis 2, **dadurch gekennzeichnet, dass** das erste Endstück (6a) des Verbindungselementes (6) buchsenförmig, dass das zweite Endstück (6b) stiftförmig, dass das erste oder zweite Kontaktelement (4, 5) stiftförmig und dass das zweite oder erste Kontaktelement (5, 4) buchsenförmig ausgebildet ist.

16. Befestigungseinrichtung nach Anspruch 15, **dadurch gekennzeichnet, dass** das erste oder zweite stiftförmige Kontaktelement (4, 5) ein Drahtstift ist.

17. Befestigungseinrichtung nach Anspruch 16, **dadurch gekennzeichnet, dass** das buchsenförmige erste Endstück (6a) des Verbindungselementes (6) einen Klemmring (63) ausbildet, dessen Klemmdurchmesser (KD) geringfügig kleiner ist als der Außendurchmesser (AD) des zugehörigen ersten oder zweiten Kontaktelementes (4, 5), und dass das erste Endstück (6a) einen zur axialen Mitte (M) hin anschließenden Hohlraum (61) aufweist, dessen Innendurchmesser (ID) geringfügig größer ist als der Außendurchmesser (AD) des ersten oder zweiten Kontaktelementes (4, 5).

18. Befestigungseinrichtung nach Anspruch 17, **dadurch gekennzeichnet, dass** das buchsenförmig ausgebildete erste Endstück (6a) axial verlaufende Schlitze (65) zum axialen Ende (E) hin aufweist und dass Kontaktfinger (64) zwischen den Schlitzen (65) ausgebildet sind.

19. Befestigungseinrichtung nach Anspruch 18, **dadurch gekennzeichnet, dass** die Kontaktfinger (64) in Richtung zum axialen Ende (E) und zur Längsachse (L) des Verbindungselementes (6) hin gebogen sind.

20. Befestigungseinrichtung nach einem der Ansprüche 17 bis 19, **dadurch gekennzeichnet, dass** das buchsenförmig ausgebildete erste Endstück (6a) eine trichterförmige, den Klemmring (62) ausbildende Einschnürung (62) aufweist.

21. Befestigungseinrichtung nach einem der Ansprüche 15 bis 20, **dadurch gekennzeichnet, dass** das stiftförmige zweite Endstück (6b) des Verbindungselementes (6) ein Drahtstift ist.

22. Befestigungseinrichtung nach einem der vorangegangenen Ansprüche, **dadurch gekennzeichnet, dass** die Kontaktelemente (4, 5) und das Verbindungselement (6) aus verzinntem Kupfer oder Kupferlegierungen bestehen.

23. Elektronisches Gerät mit einer ersten und zweiten elektronischen Baugruppe (3, 2) mit jeweils einem Schaltungsträger (21, 31) für elektronische Bauteile (22, 32), wobei zumindest ein erstes Kontaktelement (4) auf einer Kontaktierungsseite (KS) der ersten Baugruppe (3) angeordnet ist, welches jeweils mit einem, auf einer Anschlussseite (AS) der zweiten Baugruppe (2) angeordneten zweiten Kontaktelement (5) korrespondiert, **dadurch gekennzeichnet, dass** das elektronische Gerät zur Befestigung und/oder Kontaktierung der ersten elektronischen Baugruppe (3) an die zweite elektronische Baugruppe (2) eine Befestigungseinrichtung nach einem der vorangegangenen Ansprüche aufweist.

24. Elektronisches Gerät nach Anspruch 23, **dadurch gekennzeichnet, dass** die zweite elektronische Baugruppe (2) in einem Gehäuse (23) untergebracht ist, dass das Gehäuse (23) zumindest eine Öffnung (OP) aufweist und dass im Bereich der jeweiligen Öffnung (OP) das erste Endstück (6a) des Verbindungselementes (6) der Befestigungseinrichtung angeordnet ist.

25. Elektronisches Gerät nach Anspruch 23 oder 24, **dadurch gekennzeichnet, dass** das elektronische Gerät ein Leistungshalbleitermodul mit einem Ansteuerteil als erste elektronische Baugruppe (3) und mit einem Halbleiter-Leistungsteil als zweite elektronische Baugruppe (2) ist.

## Claims

1. Fastening device for fastening and/or electrically contacting a first electronic component (3) to a second electronic component (2), with the components (2, 3) each comprising a circuit carrier (21, 31) for electronic components (22, 23) and with at least one first contact element (4) being arranged on a contacting side (KS) of the first component (3), which corresponds in each instance with a second contact element (5) arranged on a connection side (AS) of the second component (2), with the fastening device having a connecting element (6) with two opposing end pieces (6a, 6b), with the first end piece (6a) being contactable with the first contact element (4) and the second end piece (6b) being contactable with the second contact element (5) and
with the respective end pieces (6a, 6b) being connected in a hinged manner to the respective contact element (4, 5), **characterised in that**
the respective end pieces (6a, 6b) of the connecting element (6) in the first and/or second contact element (4, 5) can be axially displaced by applying force.

2. Fastening device according to claim 1, **characterised in that** the connecting element (6) has a longitudinal axis (L) and is essentially embodied so as to be rotationally symmetrical.

3. Fastening device according to one of the preceding claims, **characterised in that** the two end pieces (6a, 6b) of the connecting element (6) are embodied in the manner of a socket and the two contact elements (4, 5) are embodied in the manner of a pin.

4. Fastening device according to claim 3, **characterised in that** the socket-type end pieces (6a, 6b) form a clamping ring (63), the clamping diameter (KD) of which is marginally smaller than the outer diameter (AD) of the associated pin-type contact element (4, 5) and that the connecting element (6) has at least one cavity (61) connecting to the axial centre (M) of the connecting element, the inner diameter (ID) of which is marginally greater than the outer diameter (AD) of the associated contact element (4, 5).

5. Fastening device according to claim 4, **characterised in that** the end pieces (6a, 6b) have axial slots (65) toward the respective axial end (E) and that contact fingers (64) are embodied between the slots (65).

6. Fastening device according to claim 5, **characterised in that** the contact fingers (64) are bent in the direction toward the respective axial end (E) and toward the longitudinal axis (L) of the connecting element (6).

7. Fastening device according to one of claims 4 to 6, **characterised in that** the socket-type end pieces (6a, 6b) have a funnel-type lateral contraction (62) forming the clamping ring (63).

8. Fastening device according to one of claims 3 to 7, **characterised in that** the pin-type contact elements (4, 5) are wire pins.

9. Fastening device according to one of claims 1 to 2, **characterised in that** the connecting element (6) is embodied in the manner of a pin and the two contact elements (4, 5) are embodied in the manner of a socket.

10. Fastening device according to claim 9, **characterised in that** the connecting element (6) is a wire pin.

11. Fastening device according to claim 9 or 10, **characterised in that** the socket-type contact elements (4, 5) form a clamping ring (43, 53), the clamping diameter (KD) of which is marginally smaller than the outer diameter (AD) of the connecting element (6) and that the contact elements (4, 5) each have a cavity (41, 51) connecting to the clamping ring (43, 53) in the axial direction toward the contacting or connecting side (AS, KS), the inner diameter (ID) of which is marginally greater than the outer diameter (AD) of the connecting element (4, 5).

12. Fastening device according to claim 11, **characterised in that** the contact element (4, 5) has axial slots (65) at the respective axial end (E) opposing the connecting and/or contacting side (AS, KS) and that contact fingers (64) are embodied between the slots (65).

13. Fastening device according to claim 12, **characterised in that** the contact fingers (64) are arched toward the respective axial end (E) opposing the connecting and/or contacting side (AS, KS) and toward a longitudinal axis (LK) of the contact element (4, 5).

14. Fastening device according to one of claims 11 to 13, **characterised in that** the socket-type contact element (4, 5) has a funnel-type lateral contraction (42, 62) embodying the clamping ring (43, 53).

15. Fastening device according to one of claims 1 to 2, **characterised in that** the first end piece (6a) of the connecting element (6) is embodied in the manner of a socket, that the second end piece (6b) is embodied in the manner of a pin, that the first or second contact element (4, 5) is embodied in the manner of a pin and that the second or first contact element (5, 4) is embodied in the manner of a socket.

16. Fastening device according to claim 15, **characterised in that** the first or second pin-type contact element (4, 5) is a wire pin.

17. Fastening device according to claim 16, **characterised in that** the socket-type first end piece (6a) of the connecting element (6) embodies a clamping ring (63), the clamping diameter (KD) of which is marginally smaller than the outer diameter (AD) of the associated first or second contact element (4, 5) and that the first end piece (6a) has a cavity (61) connecting to the axial centre (M), the inner diameter (ID) of which is marginally greater than the outer diameter (AD) of the first or second contact element (4, 5).

18. Fastening device according to claim 17, **characterised in that** the socket-type first end piece (61) has axial slots (65) toward the axial end (E) and that contact fingers (64) are embodied between the slots (65).

19. Fastening device according to claim 18, **characterised in that** the contact fingers (64) are arched in the direction of the axial end (E) and of the longitudinal axis (L) of the connecting element (6).

20. Fastening device according to one of claims 17 to 19, **characterised in that** the socket-type first end piece (6a) has a funnel-shaped lateral contraction (62) embodying the clamping ring (62).

21. Fastening device according to one of claims 15 to 20, **characterised in that** the pin-type second end piece (6b) of the connecting element (6) is a wire pin.

22. Fastening device according to one of the preceding claims, **characterised in that** the contact elements (4, 5) and the connecting element (6) consist of tin-plated copper or copper alloys.

23. Electronic device with a first and second electronic component (3, 2) each having a circuit carrier (21, 31) for electronic components (22, 32), with at least a first contact element (4) being arranged on a contacting side (KS) of the first component (3), which corresponds in each instance to a second contact element (5) arranged on a connecting side (AS) of the second component (2), **characterised in that** the electronic device for fastening and/or contacting the first electronic component (3) to the second electronic component (2) has a fastening device according to one of the preceding claims.

24. Electronic device according to claim 23, **characterised in that** the second electronic component (2) is accommodated in a housing (23), that the housing (23) has at least one opening (OP) and that the first end piece (6a) of the connecting element (6) of the fastening device is arranged in the region of the respective opening (OP).

25. Electronic device according to claim 23 or 24, **characterised in that** the electronic device is a power semiconductor module with an activation element as a first electronic component (3) and with a semiconductor power element as a second electronic component (2).

## Revendications

1. Dispositif de fixation pour la fixation et/ou la mise en contact électrique d'un premier module ( 3 ) électronique sur un deuxième module ( 2 ) électronique, dans lequel les modules ( 2, 3 ) ont respectivement un porte-circuit ( 21, 31 ) pour des modules ( 22, 32 ) électroniques et dans lequel au moins un premier élément ( 4 ) de contact est disposé sur un côté ( KS ) de mise en contact du premier module ( 3 ), qui correspond respectivement à un deuxième élément ( 5 ) de contact disposé sur un côté ( AS ) de connexion du deuxième module ( 2 ), le dispositif de fixation ayant un élément ( 6 ) de liaison comprenant deux embouts ( 6a, 6b ) opposés, le premier embout ( 6a ) pouvant être mis en contact avec le premier élément ( 4 ) de contact et le deuxième embout ( 6b ) pouvant être mis en contact avec le deuxième élément ( 5 ) de contact et
dans lequel les embouts ( 6a, 6b ) respectifs sont articulés à l'élément ( 4, 5 ) de contact respectif,
**caractérisé en ce que**
les embouts ( 6a, 6b ) respectifs de l'élément ( 6 ) de liaison sont coulissants axialement dans le premier et/ou le deuxième élément ( 4, 5 ) de contact par application d'une force.

2. Dispositif de fixation suivant la revendication 1, **caractérisé en ce que** l'élément ( 6 ) de liaison a un axe ( L ) longitudinal et est sensiblement de révolution.

3. Dispositif de fixation suivant l'une des revendications précédentes, **caractérisé en ce que** les deux embouts ( 6a, 6b ) de l'élément ( 6 ) de liaison sont en forme de douille et les deux éléments ( 4, 5 ) de contact sont en forme de fiche.

4. Dispositif de fixation suivant la revendication 3, **caractérisé en ce que** les embouts ( 6a, 6b ) en forme de douille forment un anneau ( 63 ) de serrage, dont le diamètre ( KD ) de serrage est légèrement plus petit que le diamètre ( AD ) extérieur de l'élément ( 4, 5 ) de contact associé en forme de fiche et **en ce que** l'élément ( 6 ) de liaison a au moins une cavité ( 61 ) qui se raccorde vers le milieu ( M ) axial de l'élément ( 6 ) de liaison et dont le diamètre ( AD ) intérieur est légèrement plus grand que le diamètre ( AD ) extérieur de l'élément ( 4, 5 ) associé de contact.

5. Dispositif de fixation suivant la revendication 4, **caractérisé en ce que** les embouts ( 6a, 6b ) ont des fentes ( 65 ) s'étendant axialement vers l'extrémité ( E ) respective et **en ce que** des doigts ( 64 ) de contact sont formés entre les fentes ( 65 ).

6. Dispositif de fixation suivant la revendication 5, **caractérisé en ce que** les doigts ( 64 ) de contact sont courbés en direction de l'extrémité ( E ) axiale respective et vers l'axe ( L ) longitudinal de l'élément ( 6 ) de liaison.

7. Dispositif de fixation suivant l'une des revendications 4 à 6, **caractérisé en ce que** les embouts ( 6a, 6b ) en forme de douille ont un resserrement ( 62 ) en forme d'entonnoir formant l'anneau ( 63 ) de serrage.

8. Dispositif de fixation suivant l'une des revendications 3 à 7, **caractérisé en ce que** les éléments ( 4, 5 ) de contact en forme de fiche sont des fiches en fil métallique.

9. Dispositif de fixation suivant l'une des revendications 1 à 2, **caractérisé en ce que** l'élément ( 6 ) de liaison est sous la forme d'une fiche et les deux éléments ( 4, 5 ) de contact sous la forme de douille.

10. Dispositif de fixation suivant la revendication 9, **caractérisé en ce que** l'élément ( 6 ) de liaison est une fiche en fil métallique.

11. Dispositif de fixation suivant la revendication 9 ou 10, **caractérisé en ce que** les éléments ( 4, 5 ) de contact en forme de douille forment un anneau ( 43, 53 ) de serrage dont le diamètre ( KD ) de serrage est légèrement plus petit que le diamètre ( AD ) extérieur de l'élément ( 6 ) de liaison et **en ce que** les éléments ( 4, 5 ) de contact ont dans la direction axiale vers le côté ( AS, KS ) de mise en contact de connexion respectivement une cavité ( 41, 51 ) qui se raccorde à l'anneau ( 43, 53 ) de serrage et dont le diamètre ( ID ) intérieur est légèrement plus grand que le diamètre ( AD ) extérieur de l'élément ( 4, 5 ) de liaison.

12. Dispositif de fixation suivant la revendication 11, **caractérisé en ce que** l'élément ( 4, 5 ) de contact a des fentes s'étendant axialement vers l'extrémité ( E ) axiale opposée aux côtés ( AS, KS ) respectifs de connexion et de mise en contact et **en ce que** des doigts ( 64 ) de contact sont formés entre les fentes ( 65 ).

13. Dispositif de fixation suivant la revendication 12, **caractérisé en ce que** les doigts ( 64 ) de contact sont courbés vers l'extrémité ( E ) axiale respective opposée aux côtés ( AS, KS ) de connexion et de mise en contact et sont courbés vers un axe ( LK ) longitudinal de l'élément ( 4, 5 ) de contact.

14. Dispositif de fixation suivant l'une des revendications 11 à 13, **caractérisé en ce que** l'élément ( 4, 5 ) de contact en forme de douille a un resserrement ( 42, 62 ) en forme d'entonnoir formant l'anneau ( 43, 54 ) de serrage.

15. Dispositif de fixation suivant l'une des revendications 1 à 2, **caractérisé en ce que** le premier embout ( 6a ) de l'élément ( 6 ) de liaison est en forme de douille, **en ce que** le deuxième embout ( 6b ) est en forme de fiche, **en ce que** le premier ou le deuxième élément ( 4, 5 ) de contact est en forme de fiche, et **en ce que** le deuxième ou le premier élément ( 5, 4 ) de contact est en forme de douille.

16. Dispositif de fixation suivant la revendication 15, **caractérisé en ce que** le premier ou le deuxième élément ( 4, 5 ) de contact en forme de fiche est une fiche en fil métallique.

17. Dispositif de fixation suivant la revendication 16, **caractérisé en ce que** le premier embout ( 6a ) en forme de douille de l'élément ( 6 ) de liaison forme un anneau ( 63 ) de serrage dont le diamètre ( KD ) de serrage est légèrement plus petit que le diamètre ( AD ) extérieur du premier ou du deuxième élément ( 4, 5 ) associé de contact et **en ce que** le premier embout ( 6a ) a une cavité ( 61 ) qui se raccorde vers le milieu ( M ) axial et dont le diamètre ( ID ) intérieur est légèrement plus grand que le diamètre ( AB ) extérieur du premier ou du deuxième élément ( 4, 5 ) de contact.

18. Dispositif de fixation suivant la revendication 17, **caractérisé en ce que** le premier embout ( 6a ) en forme de douille a des fentes ( 65 ) s'étendant axialement vers l'extrémité ( E ) axiale et **en ce que** des doigts ( 64 ) de contact sont formés entre les fentes ( 65 ).

19. Dispositif de fixation suivant la revendication 18, **caractérisé en ce que** les doigts ( 64 ) de contact sont courbés en direction de l'extrémité ( E ) axiale et vers l'axe ( L ) longitudinal de l'élément ( 6 ) de liaison.

20. Dispositif de fixation suivant l'une des revendications 17 à 19, **caractérisé en ce que** le premier embout ( 6a ) en forme de douille a un resserrement ( 62 ) en forme d'entonnoir formant l'anneau ( 62 ) de serrage.

21. Dispositif de fixation suivant l'une des revendications 15 à 20, **caractérisé en ce que** le deuxième embout ( 6b ) en forme de fiche de l'élément ( 6 ) de liaison est une fiche en fil métallique.

22. Dispositif de fixation suivant l'une des revendications précédentes, **caractérisé en ce que** les éléments ( 4, 5 ) de contact et l'élément ( 6 ) de liaison sont en cuivre étamé ou en alliage de cuivre.

23. Appareil électronique ayant un premier et un deuxième modules ( 3, 2 ) électroniques ayant respectivement un porte-circuit ( 21, 31 ) pour des modules ( 22, 32 ) électroniques, dans lequel au moins un premier élément ( 4 ) de contact est disposé sur un côté ( KS ) de contact du premier module ( 3 ) qui correspond respectivement à un deuxième élément ( 5 ) de contact disposé sur un côté ( AS ) de connexion du deuxième module ( 2 ), **caractérisé en ce que** l'appareil électronique a, pour la fixation et/ou la mise en contact du premier module ( 3 ) électronique sur le deuxième module ( 2 ) électronique, un dispositif de fixation suivant l'une des revendications précédentes.

24. Appareil électronique suivant la revendication 23, **caractérisé en ce que** le deuxième module ( 2 ) électronique est logé dans un boîtier ( 23 ) **en ce que** le boîtier ( 23 ) a au moins une ouverture ( OP ) et **en ce que** le premier embout ( 6a ) de l'élément ( 6 ) de liaison du dispositif de fixation est disposé dans la partie de l'ouverture ( OP ) respective.

25. Appareil électronique suivant la revendication 23 ou 24, **caractérisé en ce que** l'appareil électronique est un module de puissance à semi-conducteur, ayant une partie de commande comme premier module ( 3 ) électronique et ayant une partie de puissance à semi-conducteur comme deuxième module ( 2 ) électronique.
